# EUROPÄISCHE PATENTSCHRIFT

(11) **EP 1 817 803 B1**
(45) Veröffentlichungstag und Bekanntmachung des Hinweises auf die Patenterteilung: **13.06.2012**
(21) Anmeldenummer: 05817414.5
(22) Anmeldetag: 11.11.2005
(51) Int. Cl.: H01L 41/047

(54) **KONTAKTIERUNG VON VIELSCHICHT-PIEZOAKTOREN BZW. -SENSOREN**
CONTACTING MULTILAYER PIEZO ACTUATORS OR SENSORS
MISE EN CONTACT D'ACTIONNEURS OU DE DETECTEURS PIEZOELECTIQUES MULTICOUCHES

(30) Priorität: 30.11.2004 DE 102004057795
(43) Veröffentlichungstag der Anmeldung: 15.08.2007
(73) Patentinhaber: SIEMENS AKTIENGESELLSCHAFT, 80333 München (DE)
(72) Erfinder: KASPAR, Michael, 85640 Putzbrunn (DE); MAGORI, Erhard, 85622 Feldkirchen (DE); WEINKE, Robert, 81825 München (DE)
(86) Internationale Anmeldenummer: PCT/EP2005/055925
(87) Internationale Veröffentlichungsnummer: WO 2006/058833

(56) Entgegenhaltungen:
- EP-A- 1 132 978
- EP-A- 1 162 671
- DE-A1- 3 150 696
- DE-A1- 3 308 277

## Beschreibung

Die vorliegende Erfindung betrifft einen Piezostack gemäß dem Oberbegriff des Hauptanspruchs und ein entsprechendes Verfahren.

Aus EP 1 132 978 A ist ein Multilayer-Piezostack bekannt, dessen Elektroden mit einer flexiblen Folie kontaktiert sind.

Aus DE 31 50 696 A1 ist ein Stapel aus piezoelektrischen Plättchen bekannt, bei dem jedes zweite Plättchen so aus dem Stapel hervorragt, dass die Elektrodenbeläge zum Teil freiliegen und damit selbst die flächigen Kontakte bilden. Zur Verbindung parallel zu schaltender Kontakte werden Leiterplaten verwendet, deren Leiterbahnen an die Elektrodenbeläge angelötet werden.

Aus DE 33 08 277 A1 ist ein Stapel aus piezoelektrischen Plättchen bekannt, bei dem jedes zweite Plättchen aus dem Stapel hervorragt und an seinen Elektrodenbelägen kontaktiert wird. Ragen die Plättchen nicht an gegenüberliegenden, sondern an benachbarten Seiten hervor, kann die Montage in einer einfachen Montagelehre erfolgen. Zum Anschluss der einzelnen Plättchen kann eine flexible oder starre, flexible Schaltung verwendet werden.

Herkömmlicher Weise bestehen Piezoetacks aus vielen einzelnen Aktor- oder Sensor-Schichten. Der Aufbau ist mit Keramikkondensatoren vergleichbar. Zunächst werden an je einer Kante des Aktors/Sensors alle Elektroden eines Poles miteinander durch einen aufgedruckten Metallstreifen verbunden. Beim Kondensator kann nun auf diesen Kontakt die Anschlussleitung gelötet werden. Da der Aktor/Sensor jedoch seine Länge verändert, entstehen Spannungsrisse in den kontaktierten Bereichen. Dadurch wird die Kontaktierung unterbrochen. Um Piezostacks zu kontaktieren wird deshalb an möglichst vielen Stellen die Kontaktierung mit den Anschlussleitungen flexibel verbunden. Dazu wird derzeit eine so genannte Drahtharfe aus vielen Einzeldrähten auf die Stackelektroden und Anschlussleitungen gelötet. Um diese Drahtharfe und die Aktor- bzw. Sensorelektroden voneinander zu isolieren, wird der Aktor/Sensor mit Isolationsmaterial beschichtet. Anschließend wird der Aktor/Sensor nochmals durch einen elastischen Verguss verpackt, um die Anschlussleitungen zu stabilisieren und die Drahtharfe zu schützen.

Nachteilig ist, dass durch die Aktor- bzw. Sensor-Längenveränderungen erzeugte Spannungsrisse in den kontaktierten Bereichen nicht vollständig ausgeschlossen werden können.

Es ist Aufgabe der vorliegenden Erfindung eine Kontaktierung von Piezo-Stapelaktoren (Piezostacks) preisgünstig und zuverlässig bereit zu stellen. Piezos sollen insbesondere im Fall von Aktoren sicher mit einer elektrischen Leistungsversorgungsvorrichtung und im Fall von Sensoren sicher mit einer Signalerfassungsvorrichtung elektrisch verbunden sein.

Die Aufgabe wird durch eine Vorrichtung gemäß dem Hauptanspruch und ein Verfahren gemäß dem Nebenanspruch gelöst. Weitere vorteilhafte Ausgestaltungen finden sich in den Unteransprüchen.

Die Kontaktierung erfolgt durch einen flexiblen Leiterrahmen bzw. Leadframe mit freitragenden oder freiliegenden Anschlüssen.

Ein Piezostack besteht dabei aus einer Mehrzahl aufeinander gestapelter Aktor- oder Sensor-Schichten mit Elektroden, die mittels eines flexiblen, insbesondere TAB-(tape-automated bonding), Leadframes in Form von Leiterstrukturen auf einer Isolierfolie mit freitragenden Leiterstrukturbereichen über Öffnungen der Isolierfolie kontaktiert sind. Unter den Elektroden des Piezostacks werden hier die Stellen jedes Piezos verstanden, die mit den freitragenen Leiterstrukturen, insbesondere mittels eines Verbindungsmaterials kontaktiert sind. Eine Elektrode grenzt dabei entweder an einen positiv oder einen negativ gepolten Bereich eines Piezos an. Elektroden sind Piezostack-Kontaktierungen.

Diese vorteilhafte Lösung gemäß der vorliegenden Erfindung erzeugt eine Kontaktierung einzelner Stackelektroden. Dadurch werden passive Bereiche auf der Piezooberfläche vermieden und der wirkungsgrad erhöht. Zusätzlich kann die Kontaktierung beider Pole von einer Seite erfolgen (Einsparung von Kosten/Arbeitsschritten). Jedem elektrischen Pol ist eine mäanderförmige Leiterstruktur zugeordnet, die zueinander parallel verlaufen. Damit wird auf vorteilhafte Weise jeder Piezo bzw. jede Piezoschicht direkt mit dem Pluspol und dem Minuspol verbunden.

Gemäß einer vorteilhaften Ausgestaltung sind alle Elektroden des Piezostacks auf einer Seite des Piezostacks angeordnet.

Gemäß einer weiteren vorteilhaften Ausgestaltung sind die Piezos derart gestapelt, dass Bereiche gleicher Polung aneinander anliegen und in deren Übergangsbereich eine gemeinsame Elektrode angeordnet ist.

Gemäß einer weiteren vorteilhaften Ausgestaltung ist der Leadframe mit der Seite seiner Isolierfolie auf dem Piezostack fixiert. Dadurch sind die Leiterstrukturen auf einfache Weise zu den Piezos im Bereich außerhalb der Elektroden elektrisch isoliert. Die Leadframefolie sollte dünn sein, damit die Distanz zwischen freitragenden Bereichen der Leiterstrukturen und den Elektroden einfacher durch Verbindungsmaterial überbrückt werden kann.

Unter Isolierfolie wird durchgängig elektrisch nicht leitende Folie verstanden.

Gemäß einer weiteren vorteilhaften Ausgestaltung ist der Leadframe mit der Seite der Leiterstrukturen auf dem Piezostack fixiert, wobei zwischen Leiterstrukturen und den Piezos eine zusätzliche Isolierung zur Vermeidung von Kurzschlüssen ausgebildet ist. Damit ist die Distanz der freitragenden Bereiche der Leiterstrukturen zu den Elektroden verringert. D.h. leitfähiges Verbindungsmaterial muss lediglich eine relativ kurze Distanz überbrücken.

Gemäß einer weiteren vorteilhaften Ausgestaltung weisen die Leiterstrukturen, optional über den Stack hinaus geführte, Anschlussflächen für Zuleitungen, insbesondere zu einer Leistungsversorgung oder zu einer Signalerfassung, auf.

Gemäß einer weiteren vorteilhaften Ausgestaltung sind die Leiterstrukturen mit Elektroden und Zuleitungen mittels leitfähiger Verbindungsmaterialien kontaktiert.

Bei einem Verfahren zur Kontaktierung von Piezostacks, wird ein flexibler Leadframe, insbesondere TAB-Leadframe, erzeugt, der Leiterstrukturen auf einer Isolierfolie und der elektrischen Verbindung mit den Elektroden dienenden freitragende Bereiche der Leiterstrukturen über Öffnungen der Isolierfolie aufweist, und dessen Positionen der freitragenden Bereiche an die Positionen der zu kontaktierenden Elektroden angepasst sind. Danach erfolgt die Aufbringung von Verbindungsmaterial, beispielsweise von Lotballs oder Lotpaste auf die zu kontaktierenden Elektroden, das Positionieren des Leadframes auf den Elektroden, die Aktivierung des Verbindungsmaterials durch Löten, beispielsweise Bügellöten oder Reflowlöten. Abschließend erfolgt das Anbringen von elektrischen Zuleitungen an dem Leadframe, insbesondere zu einer Leistungsversorgung oder Signalerfassung.

Gemäß einer vorteilhaften Ausgestaltung werden beim Erzeugen des Leadframes die freitragenden Leiterstrukturen mit einer lötbaren Oberfläche versehen. Dies vereinfacht die Kontaktierung.

Gemäß einer vorteilhaften Ausgestaltung ist das Verbindungsmaterial Lotball, Lotpaste, leitfähiger Kleber und/oder ein ACA (anisotropic conductive adhesive).

Gemäß einer weiteren vorteilhaften Ausgestaltung wird die Aktivierung des Verbindungsmaterials mittels Löten, z.B. Bügellöten oder Reflowlöten, bewirkt.

Gemäß einer weiteren vorteilhaften Ausgestaltung erfolgt das Anbringen von elektrischen Zuleitungen an dem Leadframe mittels Schweißen, Bonden, Löten, Kleben mit Leitkleber, Klemmen oder Direktstecker.

Gemäß einer weiteren vorteilhaften Ausgestaltung wird auf der Leiterstrukturseite des Leadframes und/oder auf der die Elektroden aufweisenden Seite des Piezostacks eine zusätzliche Isolierung erzeugt. Diese ist insbesondere dann erforderlich, wenn der Leadframe mit der Seite der Leiterstrukturen auf die Elektrodenseite des Stacks aufgebracht wird.

Gemäß einer weiteren vorteilhaften Ausgestaltung wird zusätzlich eine Außenisolierung, ein Vibrationsschutz und/oder eine Zugentlastung mittels Tauchlackierung, Sprühlackieren, (Vakuum-)Verguss oder Spritzguss erzeugt. Zugentlastungen dienen beispielsweise der Sicherstellung der elektrischen Verbindung von Zuleitungen und Leiterstrukturen.

Vorteile der vorliegenden Erfindung:
- Auf das Anbringen des aufgedruckten Metallstreifens kann verzichtet werden.
- Das Verfahren erlaubt sehr große Gestaltungsfreiheit.
- Die Isolation des Stacks wird wesentlich dünner (je nach eingesetzter TAB-Folie).
- Die Wärmeableitung wird verbessert.
- Das Verfahren ist prozesssicher.
- Ein Großteil des Verfahren erfolgt automatisiert im Rollto-Roll-Prozess.
- Durch die Gestaltungsfreiheit kann die Stabilität erhöht werden:
   □ Definition von gewollten Rissstellen oder
   □ spannungsoptimiertes rissfreies Design
- Einzelne Elektroden können kontaktiert werden unter Vermeidung passiver Bereiche im Stack. Somit werden Spannungsrisse durch passive Bereiche ausgeschlossen. Die Elektroden des Stacks brauchen nicht strukturiert hergestellt werden.
- Erhöhter Wirkungsgrad, da die gesamte Aktorfläche aktiv ist und auf passive Bereiche verzichtet werden kann.
- Das Verfahren ermöglicht die Kontaktierung beider Pole auf einer Seite. Damit entfallen Prozesskosten für zweiseitige Bearbeitung.
- Alle Prozesse sind großserientauglich.
- Die elektrische Spannungsfestigkeit und Zuverlässigkeit werden erhöht und genauer definiert.
- Die verbesserte Eigenschaften ermöglichen den Einsatz kleinerer Stacks und somit Kosteneinsparung.

Die vorliegende Erfindung wird anhand von Ausführungsbeispielen in Verbindung mit den Figuren näher beschrieben. Es zeigen
- Figur 1: ein erstes Ausführungsbeispiel einer erfindungsgemäßen Vorrichtung;
- Figur 2: ein zweites Ausführungsbeispiel einer erfindungsgemäßen Vorrichtung.

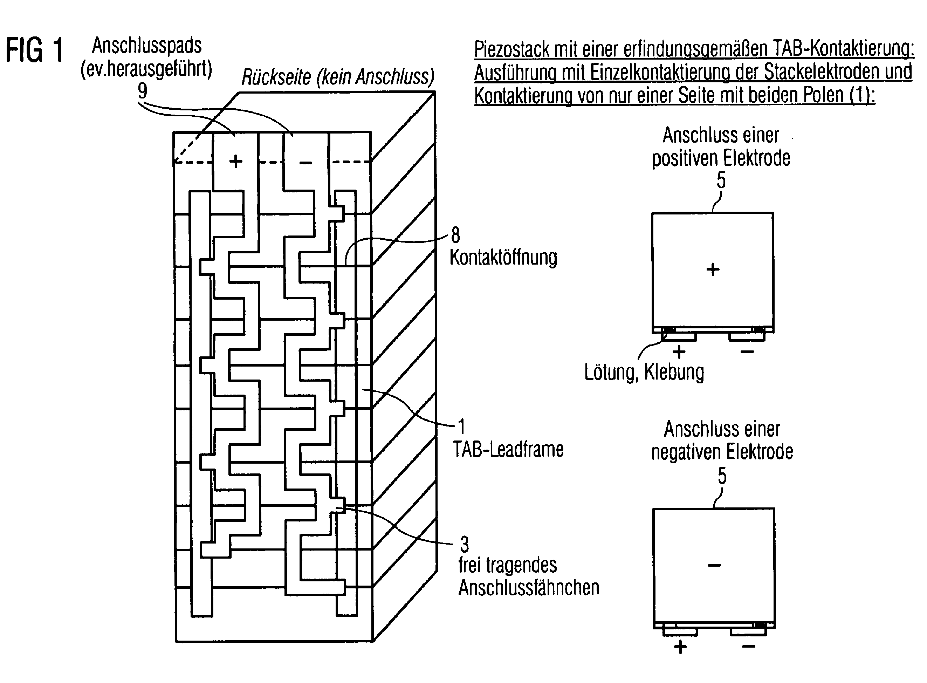

Fig. 1 zeigt ein erstes Ausführungsbeispiel, bei dem ein Leadframe 1 auf einem Piezostack 2 positioniert ist.

Der flexible Leadframe 1 weist Leiterstrukturen 4 auf einer Isolierfolie 6 auf und ist über Öffnungen 8 der Isolierfolie 6 erzeugte freitragende oder freiliegende Bereiche 3 der Leiterstrukturen 4 mit Elektroden 5 des Piezostacks 2 elektrisch verbunden. Die Leiterstrukturen 4 sind hier flächige Leiterbahnen. Öffnungen 8 sind streifenförmige Aussparungen der Isolierfolie 6. Diese Kanäle liegen zueinander parallel und ergeben sich aus den Positionen der Elektroden 5 des Piezostacks 2. Andere Formen von Öffnungen 8 sind ebenso möglich. Die Mäanderform der Leiterbahnen dient einer optimalen Kontaktierung bei guter Isolierung und ist der Piezodicke angepasst (beispielsweise liegt die Piezodicke bei 50 bis 100 µm). Als Leitermaterial eignen sich z.B. Kupfer oder Aluminium. Die Isolierfolie 6 besteht beispielsweise aus einem Polymer.

Zunächst können folgende Aufbauschritte durch geführt werden:
1. Aufbau eines TAB-Leadframe 1 mit alternierenden freitragenden Anschlussbeinchen bzw. freitragende Bereiche 3 der Leiterstrukturen 4 im Raster der Piezostacks 2. Optional können die Anschlussbeinchen 3 (oder auch als Anschlussfähnchen 3 bezeichnet) mit einer lötbaren Oberfläche versehen werden.
2. Aufbringen von Lotballs oder Lotpaste an den Piezostacks-Kontaktierungen bzw. Elektroden 5.
3. Positionieren des Leadframe 1 und Lötung durch zum Beispiel Bügellöten oder Reflowlöten.

Der Leadframe 1 kann auf zwei Arten positioniert sein. Gemäß dem ersten Ausführungsbeispiel nach Fig. 1 erfolgt eine Positionierung des Leadframes 1 mit den Anschlussbeinchen 3 auf der dem Stack 2 abgewandten Seite. Der Leadframe liegt mit seiner Isolierfolie 6 an der die Elektroden 5 aufweisenden Seite des Stacks 2 an. Gemäß diesem Ausführungsbeispiel ist eine möglichst dünne Leadframefolie 6 erforderlich, um die Distanz der Anschlussbeinchen 3 zum Stack 2 gering zu halten. Diese Distanz muss über eine entsprechende Höhe an leitfähigem Verbindungsmaterial (Lotball, Lotpaste, leitfähiger Kleber, ACA etc.) überbrückt werden. Die Isolierung der Leiterstrukturen 4 zum Stack erfolgt über das Trägermaterial, d.h. die Isolierfolie 6, des Leadframe 1.

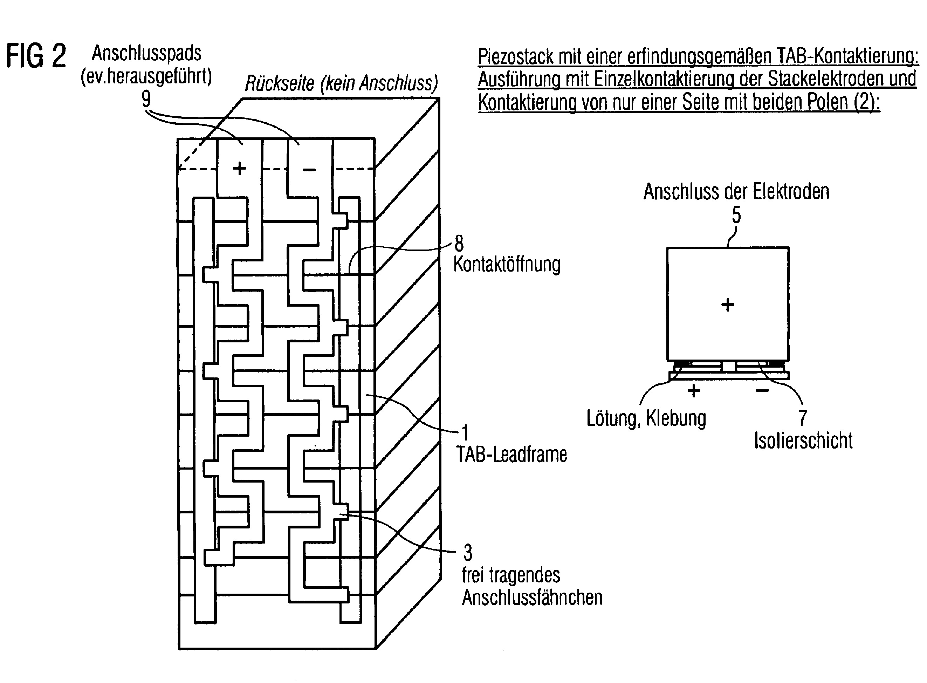

Gemäß einem zweiten Ausführungsbeispiel nach Fig. 2 erfolgt die Positionierung des Leadframes 1 mit den Anschlussbeinchen 3 zum Stack 2 hin. D.h. der Leadframe 1 liegt mit der Seite der Leiterstrukturen 4 an der die Elektroden 5 aufweisenden Seite des Piezostacks 2 an. Erforderlich ist eine Isolierung 7 der Leiterstrukturen 4 um einen Kurzschluss zwischen den Polen zu vermeiden. Diese Isolierung 7 kann während des Leadframeprozesses aufgebracht werden oder der Piezostack 2 kann die Isolierung 7 aufweisen. Die Verbindung wird erneut über ein leitfähiges Verbindungsmaterial hergestellt (Lotball, Lotpaste, leitfähiger Kleber). Alternativ kann über eine ACA-Verklebung (anisotropic conductive adhesive) die Isolierung und gleichzeitige Kontaktierung erfolgen.

Als 4. und letzter Aufbauschritt erfolgt das Anbringen beliebiger Zuleitungen, zum Beispiel durch Schweißen, Bonden, Löten, Kleben mit Leitkleber, Klemmen oder Direktstecker. Optional kann eine Außenisolierung, ein Vibrationsschutz und/oder eine Zugentlastung mit geeigneten Verfahren (Tauchlackierung, Sprühlackieren, (Vakuum-)Verguss, Spritzguss etc.) erzeugt sein. Dieser Verfahrensschritt wird, ebenso wie die Verfahrensschritte 1 und 2, bei beiden Ausführungsbeispielen gleich ausgeführt.

Gemäß beiden Ausführungsbeispielen weisen die Leiterstrukturen 4 einen mäanderförmigen Verlauf auf und verlaufen zueinander parallel.

Andere Ausführungsformen hinsichtlich der Ausgestaltung des Leadframes 1 sind ebenso im Schutzbereich dieser Anmeldung umfasst.

Zum Schutzbereich gehören ebenso die Verfahren zur Erzeugung der Vorrichtungen gemäß Fig. 1 und Fig. 2.

## Patentansprüche

1. Piezostack (2) bestehend aus einer Mehrzahl aufeinander gestapelter Aktor- oder Sensor-Schichten mit Elektroden (5) bzw. Piezostack (2)-Kontaktierungen,
wobei
ein flexibler Leadframe (1) mit den Elektroden (5) elektrisch verbunden ist, **dadurch gekennzeichnet, dass** jedem elektrischen Pol eine mäanderförmige Leiterstruktur (4) zugeordnet ist, wobei die Leiterstrukturen zueinander parallel verlaufen.

2. Piezostack nach Anspruch 1,
**dadurch gekennzeichnet, dass**
der flexible Leadframe (1) Leiterstrukturen (4) auf einer Isolierfolie (6) aufweist und über Öffnungen (8) der Isolierfolie (6) erzeugte freitragende Bereiche (3) der Leiterstrukturen (4) mit den Elektroden (5) elektrisch verbunden ist.

3. Piezostack nach Anspruch 1 oder 2,
**dadurch gekennzeichnet, dass**
alle Elektroden (5) auf einer Seite des Piezostacks (2) angeordnet sind.

4. Piezostack nach einem oder mehreren der vorangehenden Ansprüche,
**dadurch gekennzeichnet, dass**
die Piezos derart gestapelt sind, dass Bereiche gleicher Polung aneinander anliegen und in deren Übergangsbereich eine gemeinsame Elektrode angeordnet ist.

5. Piezostack nach einem oder mehreren der vorangehenden Ansprüche,
**dadurch gekennzeichnet, dass**
der Leadframe (1) mit der Seite der Isolierfolie (6) auf dem Piezostack (2) fixiert ist.

6. Piezostack nach einem oder mehreren der vorangehenden Ansprüche,
**dadurch gekennzeichnet, dass**
der Leadframe (1) mit der Seite der Leiterstrukturen (4) auf dem Piezostack (2) fixiert ist und zwischen Leiterstrukturen (4) und den Piezos eine Isolierung (7) ausgebildet ist.

7. Piezostack nach einem oder mehreren der vorangehenden Ansprüche,
**dadurch gekennzeichnet, dass**
die Leiterstrukturen (4) optional über den Piezostack (2) hinaus geführte Anschlussflächen (9) für Zuleitungen, insbesondere zu einer Leistungsversorgung oder zu einer Signalerfassung, aufweisen.

8. Piezostack nach einem oder mehreren der vorangehenden Ansprüche,
**dadurch gekennzeichnet, dass**
die Leiterstrukturen (4) mit Elektroden (5) und Zuleitungen mittels leitfähiger Verbindungsmaterialien kontaktiert sind.

9. Verfahren zur elektrischen Kontaktierung eines Piezostacks (2) nach einem der vorherigen Ansprüche,
**gekennzeichnet durch**
- Erzeugen eines an die Positionen der zu kontaktierenden Elektroden (5) angepassten Leadframes (1),
- Aufbringung von leitfähigem Verbindungsmaterial auf die zu kontaktierenden Elektroden (5),
- Positionieren des Leadframes (1) auf den Elektroden (5),
- Aktivierung des Verbindungsmaterials,
- Anbringen von elektrischen Zuleitungen an dem Leadframe (1), insbesondere zu einer Leistungsversorgung oder Signalerfassung.

10. Verfahren nach Anspruch 9,
**dadurch gekennzeichnet, dass**
beim Erzeugen des Leadframes (1) die freitragenden Leiterstrukturen (4) mit einer lötbaren Oberfläche versehen werden.

11. Verfahren nach einem oder mehreren der vorangehenden Ansprüche 9 und 10,
**dadurch gekennzeichnet, dass**
das Verbindungsmaterial Lotball, Lotpaste, leitfähiger Kleber und/oder ein ACA (anisotropie conductive adhesive) ist.

12. Verfahren nach einem oder mehreren der vorangehenden Ansprüche 9 bis 11,
**dadurch gekennzeichnet, dass**
die Aktivierung des Verbindungsmaterials mittels Löten, z.B. Bügellöten oder Reflowlöten, bewirkt wird.

13. Verfahren nach einem oder mehreren der vorangehenden Ansprüche 9 bis 12,
**dadurch gekennzeichnet, dass**
das Anbringen von elektrischen Zuleitungen an dem Leadframe (1) mittels Schweißen, Bonden, Löten, Kleben mit Leitkleber, Klemmen oder Direktstecker erfolgt.

14. Verfahren nach einem oder mehreren der vorangehenden Ansprüche 9 bis 13,
**dadurch gekennzeichnet, dass**
auf der Leiterstrukturseite des Leadframes (1) und/oder auf der die Elektroden (5) aufweisenden Seite des Piezostacks (2) eine zusätzliche Isolierung (7) erzeugt wird.

15. Verfahren nach einem oder mehreren der vorangehenden Ansprüche 9 bis 13,
**dadurch gekennzeichnet, dass**
zusätzlich eine Außenisolierung, ein Vibrationsschutz und/oder eine Zugentlastung mittels Tauchlackierung, Sprühlackieren, (Vakuum-)Verguss oder Spritzguss erzeugt wird.

## Claims

1. Piezo stack (2) consisting of a plurality of actuator or sensor layers stacked on one another with electrodes (5), whereby a flexible leadframe (1) is electrically connected to the electrodes (5), **characterised in that** each electrical pole is assigned a serpentine conductor structure (4), whereby the conductor structures run in parallel to one another.

2. Piezo stack according to claim 1,
**characterised in that**
the flexible leadframe (1) features conductor structures (4) on an insulating foil (6) and freely-supporting areas (3) of the conductor structures (4) are connected electrically via openings (8) of the insulating foil (6) to the electrodes (5).

3. Piezo stack according to claim 1 or 2,
**characterised in that**
all electrodes (5) are arranged on one side of the piezo stack (2)

4. Piezo stack according to one or more of the preceding claims,
**characterised in that**
the piezo layers are stacked so that areas with the same polarity are adjacent to one another and a common electrode is arranged in their transition areas.

5. Piezo stack according to one or more of the preceding claims,
**characterised in that**
the leadframe (1) is fixed to the piezo stack (2) with the side of the insulating foil (6).

6. Piezo stack according to one or more of the preceding claims,
**characterised in that**
the leadframe (1) is fixed to the piezo stack (2) with the side of the conductor structures (4) and an insulation (7) is formed between conductor structures (4) and the piezo layers.

7. Piezo stack according to one or more of the preceding claims,
**characterised in that**
the conductor structures (4) have connection surfaces (9) optionally routed out above the piezo stack (2) for connecting leads, especially for a power supply or to a signal detection facility.

8. Piezo stack according to one or more of the preceding claims,
**characterised in that**
the conductor structures (4) are contacted with electrodes (5) and leads by means of conductive connection materials.

9. Method for electrical contacting of a piezo stack (2) according to one of the preceding claims,
**characterised by**
- Creation of a leadframe (1) adapted to the positions of the electrodes to be contacted (5),
- Application of conductive connection material to the electrodes (5) to be contacted,
- Positioning of the leadframe (1) on the electrodes (5),
- Activation of the connection material,
- Application of electrical leads to the leadframe (1), especially for power supply or signal detection.

10. Method according to claim 9,
**characterised in that**,
during creation of the leadframes (1) the self-supporting conductor structures (4) are provided with a solderable surface.

11. Method according to one or more of the preceding claims 9 and 10,
**characterised in that**
the connecting material is solder ball, solder paste, conductive adhesive and/or ACA (anisotropic conductive adhesive).

12. Method according to one or more of the preceding claims 9 to 11,
**characterised in that**
the connecting material is activated by means of soldering, e.g. ball soldering or reflow soldering.

13. Method according to one or more of the preceding claims 9 to 12,
**characterised in that**
the electrical leads are attached to the leadframe (1) by means of welding, bonding, soldering, gluing with conductive adhesive, terminals or direct connectors.

14. Method according to one or more of the preceding claims 9 to 13,
**characterised in that**
an additional insulation (7) is created on the conductor structure side of the leadframe (1) and/or on the side of the piezo stack (2) featuring the electrodes (5).

15. Method according to one or more of the preceding claims 9 to 13,
**characterised in that**
an outer insulation, a vibration protection and/or a strain relief is additionally created by means of dip varnishing, spray varnishing (vacuum) moulding or injection moulding.

## Revendications

1. Pile de piézo-éléments (2), composée d'une pluralité de couches superposées d'actionneurs ou de capteurs avec des électrodes (5) resp. contacts de pile de piézo-éléments (2), une grille de conducteurs flexible (1) étant reliée électriquement aux électrodes (5), **caractérisée en ce qu'**une structure de conducteurs en méandre (4) est associée à chaque pôle électrique, les structures de conducteurs étant parallèles entre elles.

2. Pile de piézo-éléments selon la revendication 1, **caractérisée en ce que** la grille de conducteurs flexible (1) présente des structures de conducteurs (4) sur une feuille isolante (6) et est reliée électriquement aux électrodes (5) via des zones (3) des structures de conducteurs (4), lesquelles zones sont en saillie et sont créées par des orifices (8) de la feuille isolante (6).

3. Pile de piézo-éléments selon la revendication 1 ou 2, **caractérisée en ce que** toutes les électrodes (5) sont situées sur un côté de la pile de piézo-éléments (2).

4. Pile de piézo-éléments selon l'une ou plusieurs des revendications précédentes,
**caractérisée en ce que**
les piézo-éléments sont empilés de manière telle que des zones de même polarité sont appliquées les unes contre les autres et qu'une électrode commune est située dans leur zone de jonction.

5. Pile de piézo-éléments selon l'une ou plusieurs des revendications précédentes,
**caractérisée en ce que**
la grille de conducteurs (1) est fixée avec le côté de la feuille isolante (6) sur la pile de piézo-éléments (2).

6. Pile de piézo-éléments selon l'une ou plusieurs des revendications précédentes,
**caractérisée en ce que**
la grille de conducteurs (1) est fixée avec le côté des structures de conducteurs (4) sur la pile de piézo-éléments (2) et une isolation (7) est réalisée entre des structures de conducteurs (4) et les piézo-éléments.

7. Pile de piézo-éléments selon l'une ou plusieurs des revendications précédentes,
**caractérisée en ce que**
les structures de conducteurs (4) présentent des surfaces de connexion (9), qui vont au-delà de la pile de piézo-éléments (2), pour des lignes d'alimentation, en particulier pour une alimentation en puissance ou une détection de signaux.

8. Pile de piézo-éléments selon l'une ou plusieurs des revendications précédentes,
**caractérisée en ce que**
les structures de conducteurs (4) sont en contact avec des électrodes (5) et des lignes d'alimentation au moyen de matières de liaison conductrices.

9. Procédé pour contacter électriquement une pile de piézo-éléments (2) selon l'une des revendications précédentes, **caractérisé par** :
- la création d'une grille de conducteurs (1) adaptée aux positions des électrodes (5) à contacter ;
- l'application d'une matière de liaison conductrice sur les électrodes (5) à contacter ;
- le positionnement de la grille de conducteurs (1) sur les électrodes (5) ;
- l'activation de la matière de liaison ;
- le montage de lignes d'alimentation électrique sur la grille de conducteurs (1), en particulier pour une alimentation en puissance ou une détection de signaux.

10. Procédé selon la revendication 9,
**caractérisé en ce que**,
lors de la création de la grille de conducteurs (1), les structures de conducteurs (4) en saillie sont pourvues d'une surface brasable.

11. Procédé selon l'une ou plusieurs des revendications précédentes 9 et 10,
**caractérisé en ce que**
la matière de liaison est une bille de brasure, une pâte de brasure, une colle conductrice et/ou un ACA (conductive adhésive anisotropic).

12. Procédé selon l'une ou plusieurs des revendications précédentes 9 à 11,
**caractérisé en ce que**
l'activation de la matière de liaison est provoquée par brasage, par exemple, brasage avec barrette chauffée ou brasage par refusion.

13. Procédé selon l'une ou plusieurs des revendications précédentes 9 à 12,
**caractérisé en ce que**
le montage de conduites d'alimentation électriques sur la grille de conducteurs (1) s'effectue par soudage, bonding, brasage, collage avec une colle conductrice, des pinces ou un connecteur direct.

14. Procédé selon l'une ou plusieurs des revendications précédentes 9 à 13,
**caractérisé en ce que**
est créée une isolation additionnelle (7) sur le côté des structures conductrices de la grille de conducteurs (1) et/ou sur le côté de la pile de piézo-éléments (2) qui comporte les électrodes (5).

15. Procédé selon l'une ou plusieurs des revendications précédentes 9 à 13,
**caractérisé en ce que**
est additionnellement créée une isolation extérieure, une protection contre les vibrations et/ou un délestage de traction par laquage au trempé, laquage par pulvérisation, moulage (sous vide) ou moulage par injection.
